# EUROPEAN PATENT APPLICATION

(11) **EP 1 881 608 A1**
(43) Date of publication of application: **23.01.2008**
(21) Application number: 06014838.4
(22) Date of filing: 17.07.2006
(51) Int. Cl.: H03L 7/23, H04B 1/40

(54) **Radio frequency transceiver**

(71) Applicant: VIA Technologies, Inc., Taipei, Taiwan (TW)
(72) Inventor: Lin, Jyh-Fong, Hsin-Tien, Taipei (TW); Liu, Jung-Chang, Hsin-Tien, Taipei (TW); Chen, Peir-Weir, Hsin-Tien, Taipei (TW); Tseng, Ying-Che, Hsin-Tien, Taipei (TW); Shih, Did-Min, CA 95035 (US)
(74) Representative: Wiebusch, Manfred

(57) **Abstract**

A wireless communication device. The wireless communication device comprises first (218) and second (214) programmable frequency dividers, a mixer (212), a modulator (202), a phase detector (204), and a variable controlled oscillator. The first programmable frequency divider (218) divides the frequency of a reference signal by a factor N to generate a modulating signal. The second programmable frequency divider (214) divides the reference signal by a factor M and outputs a frequency-divided signal. The factors N and M are positive integers. The mixer (212) down-converting a transmission signal according the divided signal and outputs a translation-loop signal. The modulator (202) modulates the modulating signal with baseband signals, and outputs a comparison signal. The phase detector (204) detects a phase difference between the comparison signal and the translation-loop signal. The variable controlled oscillator (210) modifies the transmission signals according to an output of the phase detector.

## Description

### BACKGROUND OF THE INVENTION

### Field of the Invention

The invention relates to reception and transmission of radio frequency signals, and in particular to reception and transmission more than one radio frequency band.

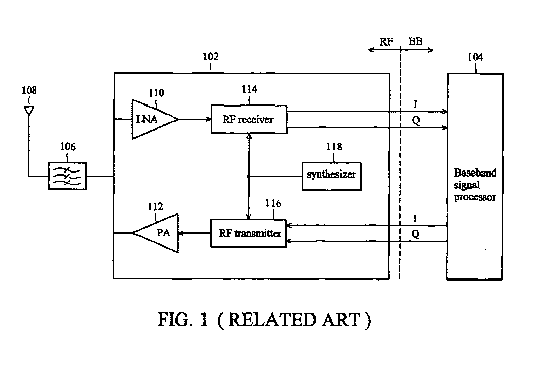

Fig. 1 shows a block diagram of a generic communication unit. A communication unit can be roughly separated into 3 parts: radio frequency (RF) transceiver 102, baseband (BB) signal processor 104, and antenna 108. The antenna 108 receives signals from the air, or transmits the signals into the air. A filter 106 blocks out undesired signals, then sends them to the RF transceiver 102. The low noise amplifier (LNA) 110 amplifies desired signals, and the RF receiver 114 down-converts the frequency of signals into baseband. Usually, baseband signals include in-phase (I) and quardature (Q) signals. The I/Q signals are sent to baseband signal processor 104 for further processing, such as decoding, decompressing, etc. The RF transmitter 116 is in charge of signal transmission, modulating 2 outgoing baseband signals into radio frequency. The power amplifier (PA) 112 pumps the RF signals from the RF transmitter 116 to an appropriate power level. The synthesizer 118 generates reference signals of a proper frequency, thus the RF receiver 114/transmitter 116 can down-convert/up-convert signals into desired bands.

In some communication systems, such as the Global System for Mobile Communications (GSM) system, it is particularly efficient to integrate component functions since transmission and reception are not performed simultaneously, such that synthesizer, receiver and transmitter functions are utilized more efficiently. However, when functions are integrated, mobile communication devices operating in GSM wireless communication systems become particularly vulnerable to undesirable interactions between signals.

The synthesizer 118 generates a periodic waveform by a variable controlled oscillator. The frequency of the variable controlled oscillator must be adjustable since the RF transmitter 116 is often required to transmit on many different frequency channels within a transmission band. For use in the widely disparate frequency ranges of the GSM, DCS (digital communication system), and PCS (personal communication service) wireless communication systems, of which the transmission bands are 824-915, 1710-1785, and 1850-1910 MHz, respectively, an RF transceiver must cover the above frequency bands.

Ideally, a transceiver synthesizer contains multiple oscillators, each corresponding to only one single band, to eliminate spurious effects between bands. However, multi-band handsets using a synthesizer with multiple oscillators require off-chip components such as surface acoustic wave (SAW) filters. These off-chip components tend to consume excessive space and increase product cost. Thus, an RF transceiver for multiple bands without SAW filters or undesired frequency interaction is desirable.

### BRIEF SUMMARY OF INVENTION

A detailed description is given in the following embodiments with reference to the accompanying drawings.

The invention provides a wireless communication device, comprising a first and a second programmable frequency divider, a mixer, a modulator, a phase detector, and variable controlled oscillator. The first programmable frequency divider divides the frequency of a reference signal by a factor N to generate a modulating signal, wherein N is a positive integer. The modulator modulates the modulating signal with baseband signals, and outputs a comparison signal. The second programmable frequency divider divides the frequency of the reference signal by a factor M, and outputs a divided signal, wherein the factor M is a positive integer. The mixer down-converts a transmission signal according to the divided signal to output a translation-loop signal. The phase detector detects a phase difference between the comparison signal and the translation-loop signal. The variable controlled oscillator modifies the transmission signal according to an output of the phase detector.

The invention also provides a method for transmitting information, comprising dividing the frequency of a reference signal by a factor of N to generate a modulating signal, dividing the frequency of the reference signal by a factor of M to generate a divided signal, down-converting a transmission signal according to the divided signal and outputting a translation-loop signal, modulating a baseband signal with the modulating signal to output a comparison signal, detecting the phase difference between the comparison signal and the translation-loop signal to generate a phase difference signal, and modifying the transmission signal according to the phase difference signal. Here, both the factors N and M are positive integers.

### BRIEF DESCRIPTION OF DRAWINGS

The present invention can be more fully understood by reading the subsequent detailed description and examples with references made to the accompanying drawings, wherein:

Fig. 1 shows a block of generic communication unit;

Fig. 2 is a block diagram of a wireless communication device according to an embodiment of the invention;

Fig. 3, 4, and 5 show three embodiments of RF transceivers according to embodiments of the invention; and

Fig. 6 shows a method for transmitting and receiving signals.

### DETAILED DESCRIPTION OF INVENTION

The following description is of the best-contemplated mode of carrying out the invention. This description is made for the purpose of illustrating the general principles of the invention and should not be taken in a limiting sense. The scope of the invention is best determined by reference to the appended claims.

An embodiment of the present invention provides a wireless communication device capable of using single synthesizer with single local oscillator for reception and transmission. The receiver structure in the embodiment is direct conversion, and the transmission structure utilizes a translation loop, also known as offset phase lock loop. The translation loop cooperates with two frequency dividers, each dividing the frequency of a reference signal generated from a synthesizer. One frequency divider provides a modulating signal for up converting baseband signals. The other frequency divider provides a divided signal for down-conversion performed in the translation loop. By designing the frequency of the reference signal and the divisors of the frequency dividers, poor spectral masking or spurs can be avoided.

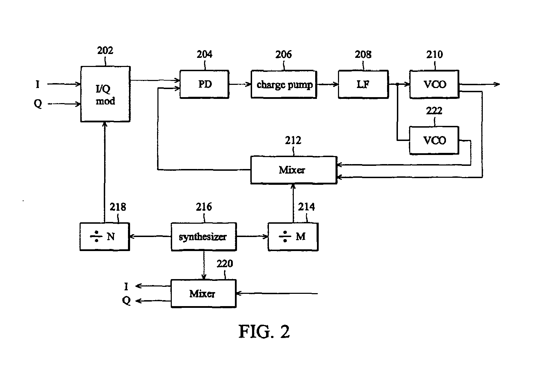

Fig. 2 is a block diagram of a wireless communication device according to an embodiment of the invention, comprising a synthesizer 216, I/Q modulator 202, first and second programmable frequency dividers 218 and 214, phase detector (PD) 204, variable controlled oscillator 210 and 222, and mixer 212. The synthesizer 216 produces a reference signal. A first programmable frequency divider 218 divides the frequency of the reference signal by a factor N to generate a modulating signal, where N is a positive integer. The I/Q modulator 202 accepts I and Q baseband signals, and mixes the modulating signal with the I and Q baseband signals to generate a comparison signal. The variable controlled oscillators 210 and 222 may be voltage controlled oscillators generating and modifying a transmission signal based upon its input signal. For the embodiment for Fig. 2, two voltage controlled oscillators 210 and 222 are preferred in order to generate GSM, DCS and PCS transmission signals. The voltage controlled oscillator 210 has a bandwidth corresponding to the GSM transmission band (of 824-915 MHz), and the voltage controlled oscillator 222 has a bandwidth corresponding to both the DCS and PCS transmission bands (of 1710-1785 and 1850-1910 MHz). The mixer 212 down-converts the transmission signal according to a divided signal, then generates the translation-loop signal. In a preferred embodiment of the invention, the mixer 212 is a harmonic mixer. The divided signal is generated by a second programmable frequency divider 214 to divide the reference signal by factor of M, where factors N and M are preferred to be relatively prime. Suppose the transmission signal has a frequency of ftrans, the divided signal from the second programmable frequency divider 214 has a frequency fdiv, then the frequency of the translation-loop signal may be ftrans-fdiv or fdiv-ftrans. In this embodiment of the invention, the translation-loop signal has the frequency of ftrans-fdiv. The phase detector 204 compares the phase of the translation-loop signal with that of the comparison signal from the I/Q modulator 202. If the phases of the two signals are aligned, no adjustment voltage is asserted and variable controlled oscillator 210 or 222 continues to oscillate at the same frequency. If one signal leads or trails the other, phase detector 204 outputs a pulse with a pulse width proportional to the phase difference between the two signals. The output pulse is commonly referred to as "up" or "down" signals and typically has a width or duration corresponding to any phase difference between the phase detector 204 input signals. The charge pump 206 generates a current that adjusts the input voltage of the variable controlled oscillator 209 based on the "up" or "down" signals received from phase detector 204. The duration or the polarity of the charge pump current is changed as necessary to correct for any phase lead or lag. If the phases of the translation-loop signal and the comparison signal of the I/Q modulator 202 are aligned, the charge pump current is substantially zero since no phase difference requires no frequency modification. The loop filter 208 develops a control voltage from the charge pump current and applies it to the variable controlled oscillator 210 and 222. A common configuration for a loop filter 208 is a simple single-pole, low-pass filter that can be realized with one resistor and one capacitor. The synthesizer 216 also sends the reference signal to the mixer 220, so that received signals can be down-converted to a desired band.

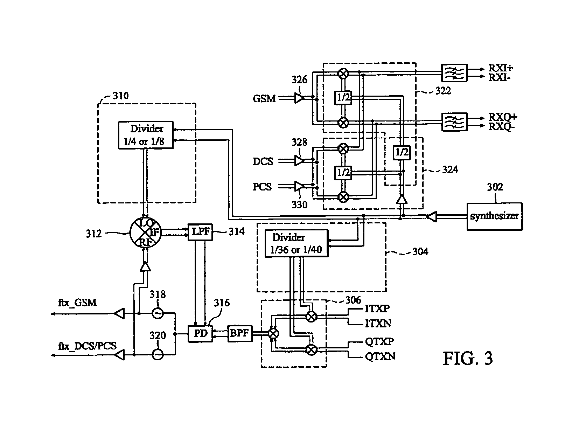

In some embodiments of the invention, a RF transceiver can be implemented as shown in Fig. 3. In Fig. 3, the synthesizer 302 may be a fractional-N synthesizer, generating a reference signal having a frequency between about 3.4GHz and 4.15GHz. The frequency of the reference signal is divided by the first programmable frequency divider 304. The first programmable frequency divider 304 divides the frequency of the reference signal by 36 or 40, depending on which mode (GSM or DCS/PCS mode) the transceiver of Fig. 3 is operated in. Mixing with the output signal of the first programmable frequency divider 304, I/Q signals of a baseband or an intermediate band are modulated at the I/Q modulator 306 to a comparison signal of an intermediate band. A second programmable frequency divider 310 divides the reference signal by 4 or 8, also depends on which mode the transceiver is operated in. A mixer 312 mixes the frequency-divided with a transmission signal to generate a translation-loop signal. The translation-loop signal is filtered by a low-pass filter 314 to send to a phase detector 316. The phase detector 316 detects the phase difference between the comparison signal and the filtered translation-loop signal. The detected results, generally after filtered by a loop filter, are sent to either voltage controlled oscillator 318 or voltage controlled oscillator 320, based upon what kind of communication the RF transceiver of Fig. 3 is operating in. The output frequency range of the oscillator 318 is from 824 to 915 MHz to cover GSM transmission band. The output frequency range of the oscillator 320 is between 1710 to 1910 MHz to cover DCS and PCS transmission bands. The synthesizer 302 also sends the reference signal into receiver mixer 322 or 324 for down-converting received signals. The low-noise amplifier (LNA) 326 receives the signals at 869-960 MHz, the LNA 328 receives the signals at 1850-1880MHz, and the LNA 330 receives the signals at 1930-1990MHz. Both the receiver mixers 322 and 324 are IQ dual mixers, each having two mixers and a frequency divider. In the receiver mixer 324, the frequency divider divides the frequency of the reference signal by 4, and the mixer, probably a double-balanced mixer, down-converts received signals according to the output signal of the frequency divider. The receiver mixer 322 functions in a similar way as the receiver mixer 324, but divides the frequency of the reference signal by 2.

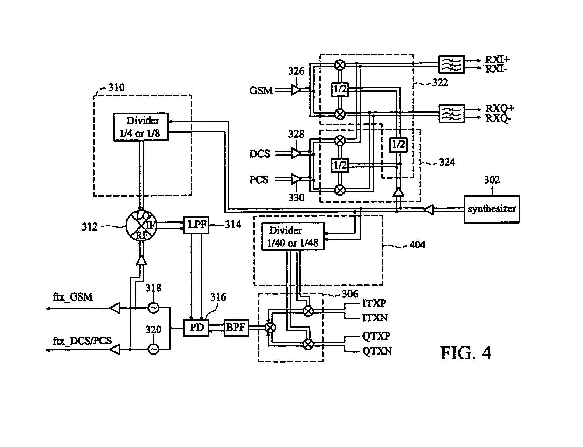

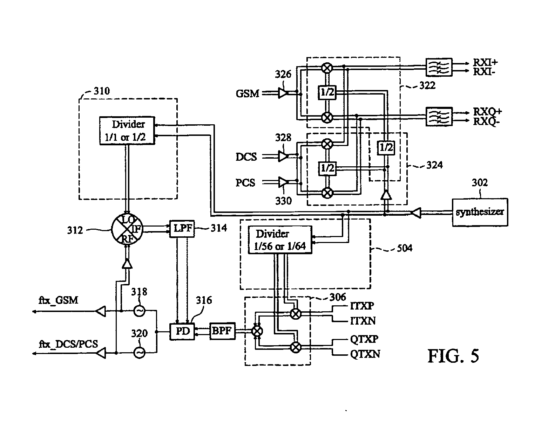

In another embodiment of the invention, the divisor of the first programmable frequency divider 404 is 40 or 48, as shown in Fig. 4. In yet another embodiment of the invention, the divisor of the first programmable frequency divider 504 is 56 or 64, as shown in Fig. 5.

The first programmable frequency divider, in another embodiment of the invention, comprises a frequency divider and a frequency multiplier. In other words, the first programmable frequency divider may divide the reference signal first by a factor of N1 and then multiply the divided reference signal by a factor N2. For example, the divisor of the first programmable divider (304, 404 or 504) may be 45, which is dividing the reference signal by a factor of 90 (N1), and then multiply the divided reference signal by 2(N2). In this embodiment of the invention, the divisor of the first programmable divider is 45, which is relatively prime in comparison to 4 or 8, the divisor of the second programmable frequency divider 310. In this way, the modulating signal and the divided signal interferences each other less, thus the signal quality of the comparison signal and the translation-loop signal is further improved.

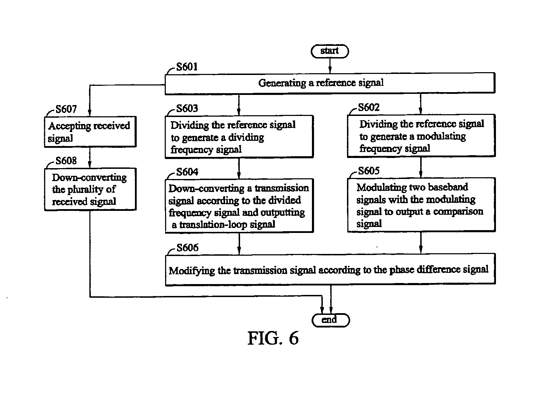

The invention also provides a method for transmitting and receiving multi-band signals, as shown in Fig. 6. The method starts with step S601, providing a reference signal. The reference signal may be generated by a synthesizer or an oscillator. Then, in steps S602 and S603, the frequency of the reference signal is divided by a factor N and a factor M, respectively, to generate a modulating signal and a divided signal. In step S604, a transmission signal is down-converted according to the divided signal and a translation-loop signal is output. Following step S602, I and Q baseband signals are modulated according to the modulating signal to output a comparison signal in step S605. In step S606, a phase difference signal is generated by detecting the phase difference between the comparison signal and the translation-loop signal, thus, the transmission signal is modified according to the phase difference signal. Steps S607 and S608 deal with signal reception and perform the steps of receiving RF signals and down-converting received RF signals according to the reference signal. Please note that only one reference signal from a single synthesizer or oscillator is discussed in the method of Fig. 6. In other words, the method provided by the invention may use only one synthesizer to perform RF signal transmission and reception.

While the invention has been described by way of example and in terms of the preferred embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A wireless communication device, comprising:
a first programmable frequency divider dividing the frequency of a reference signal by a factor N to generate a modulating signal, wherein N is a positive integer;
a modulator modulating the modulating signal with baseband signals, and outputting a comparison signal;
a second programmable frequency divider dividing the frequency of the reference signal by a factor M, and outputting a divided signal, wherein the factor M is a positive integer;
a mixer down-converting a transmission signal according to the divided signal to output a translation-loop signal;
a phase detector detecting a phase difference between the comparison signal and the translation-loop signal; and
a variable controlled oscillator modifying the transmission signal according to an output of the phase detector.

2. The wireless communication device as claimed in claim 1, wherein the modulator is an I/Q modulator, and the baseband signals are I and Q baseband signals.

3. The wireless communication device as claimed in claim 1, wherein the variable controlled oscillator generates GSM transmission signals, and further comprises a second variable oscillator generating DCS and PCS transmission signals.

4. The wireless communication device as claimed in claim 1, wherein the reference signal is generated by a synthesizer.

5. The wireless communication device as claimed in claim 4, wherein the synthesizer is a fractional-N synthesizer generating the reference signal with a frequency between about 3.4GHz and 4.15GHz.

6. The wireless communication device as claimed in claim 1, further comprising a receiver mixer down-converting received signals according to the reference signal.

7. The wireless communication device as claimed in claim 6, further comprising:
a first low noise amplifier receiving GSM signals;
a second low noise amplifier receiving DCS signals;
a third low noise amplifier receiving PCS signals;
a first reciever mixer down-converting amplified GSM signals according to the reference signal; and
a second reciever mixer down-converting amplified DCS or PCS signals according to the reference signal.

8. The wireless communication device as claimed in claim 7, wherein the first, second and third low noise amplifiers are differential input low noise amplifiers, and the first and second reciever mixers have double-balanced mixers.

9. The wireless communication device as claimed in claim 1, wherein the variable controlled oscillator comprises a voltage controlled oscillator.

10. The wireless communication device as claimed in claim 1, wherein the factors N and M are relatively prime.

11. The wireless communication device as claimed in claim 1, wherein the factor N is 36, 40, 45, 48, 56 or 64.

12. The wireless communication device as claimed in claim 1, wherein the factor M is 4 or 8.

13. The wireless communication device of claim 1, further comprising a charge pump generating a current that adjusts a control voltage of the variable controlled oscillator according to signals received from the phase detector.

14. A method for transmitting information, comprising:
dividing the frequency of a reference signal by a factor of N to generate a modulating signal;
dividing the frequency of the reference signal by a factor of M to generate a divided signal, wherein both the factors N and M are positive integers;
down-converting a transmission signal according to the divided signal and outputting a translation-loop signal;
modulating a baseband signal with the modulating signal to output a comparison signal;
detecting the phase difference between the comparison signal and the translation-loop signal to generate a phase difference signal; and
modifying the transmission signal according to the phase difference signal.

15. The method as claimed in claim 14, wherein the reference signal has a frequency at about 3.4GHz to 4.15GHz.

16. The method as claimed in claim 14, further comprising receiving a plurality of received signals and down-converting the received signals according to the reference signal.

17. The method as claimed in claim 16, further comprising dividing the reference signal, and down-converting the plurality of received signal according to the divided reference signal.

18. The method as claimed in claim 14, wherein the factors N and M are relatively prime.

19. The method as claimed in claim 14, wherein the baseband signal has I and Q baseband signals.
